Europäisches Patentamt

(19) **European Patent Office**

Office européen des brevets

(11) Numéro de publication: **0 004 511**
**B1**

(12) **FASCICULE DE BREVET EUROPEEN**

(21) Numéro de dépôt: 79400182.6

(22) Date de dépôt: 20.03.79

(51) Int. Cl.³: **H 04 N 3/14**

(54) Dispositif de lecture d'une cible de prise de vues et ensemble comportant un tel dispositif

(30) Priorité: 24.03.78 FR 7808671

(43) Date de publication de la demande:
03.10.79 Bulletin 79/20

(45) Mention de la délivrance du brevet:
26.11.80 Bulletin 80/24

(84) Etats contractants désignés:
DE GB NL

(56) Documents cités:
WIRELESS WORLD, vol. 81, n° 1471,
mars 1975,
Londres
WILLIAMS: "charges-coupled devices
imaging applications", pages 133 à 138

(73) Titulaire: "THOMSON-CSF"- SCPI
173, Boulevard Haussmann
F-75360 Paris Cedex 08 (FR)

(72) Inventeur: Felix, Pierre
"THOMSON-CSF"- SCPI 173, bld
Haussman
F-75360 Paris Cedex 08 (FR)

(74) Mandataire: Benichou, Robert, et al
"THOMSON-CSF"- SCPI bld Haussmann
F-75360 Paris Cedex 08 (FR)

Courier Press, Leamington Spa, England.

Dispositif de lecture d'une cible de prise de vues et ensemble comportant un tel dispositif

La présente invention concerne un dispositif de lecture des signaux fournis par l'ensemble des détecteurs ponctuels, ou points, d'une cible de prise de vues sous l'effet d'un rayonnement électromagnétique incident frappant la cible en question. Ces détecteurs sont disposés sur la cible suivant une matrice, aux points de croisement de lignes et de colonnes perpendiculaires entre elles.

L'invention s'applique en particulier au cas du rayonnement infra rouge.

Elle concerne également l'ensemble constitué par la cible et un tel dispositif de lecture, tous deux notamment à l'état solide.

Il s'avère généralement intéressant d'abaisser dans toute la mesure du possible le temps de lecture des lignes d'une cible et par voie de conséquence celui de la cible tout entière. Un tel abaissement permet en effet d'une part de tolérer des courants de fond continu intense et, d'autre part, des courants d'obscurité, ou courants en l'absence de tout raynonnement incident, plus grands et donc, toutes choses égales par ailleurs, de réduire le refroidissement de la cible; il est ainsi possible d'avoir recours à l'effet thermoélectrique de préférence aux moyens cryogéniques, dans le cas de cibles pour infra rouge fonctionnant par voie quantique, c'est-à-dire par création de paires électron-trou au sein du matériau de la cible par les photons incidents. De telles cibles connues de la technique utilisent des substrats en tellurure de plomb et d'étain, par exemple, sur lesquels sont formées des jonctions photo-sensibles. Dans le cas de cibles pyroélectriques, fonctionnant par échauffement du matériau de la cible, le même abaissement permet une meilleure résolution spatiale par la diminution qu'il entraîne de la diffusion latérale de chaleur autour du point d'incidence; cette diffusion est proportionnelle à la racine carrée du temps de lecture ligne en question.

Or, dans les systèmes de prise de vues, on dispose en général d'une sortie unique reliée à l'entrée unique du système de lecture, tube à rayons cathodiques des récepteurs de télévision, notamment, sur l'écran duquel sont visualisés les signaux de la cible. Dans un tel système, les signaux des détecteurs sont transmis l'un après l'autre à travers un registre unique à l'organe de visualisation, à une vitesse définie par le standard d'image adopté. Deux signaux successifs du même point de la cible sont transmis à l'écran de visualisation avec un intervalle de temps égal à celui prévu pour le balayage de la totalité de l'image dans le standard choisi; ce temps est le temps de balayage trame de l'image; il est de l'ordre de quelques dizaines de millisecondes pour les standards habituels. Le temps de balayage d'une ligne de la même cible est, lui, de l'ordre de quelques dizaines de microsecondes, dans le cas d'une ligne de 500 points avec un temps d'horloge de 1/10 de microseconde, comme dans les applications à l'infra rouge; le temps d'horloge est celui qui sépare la lecture du signal d'un point de celle du point suivant de la même ligne. On disposerait donc normalement d'un grand écart entre l'intervalle de temps séparant deux visualisations successives d'un même point de la cible sur l'écran de sortie et celui qui séparerait deux prélèvements du signal, ou interrogations successives du même point d'une ligne, dans un système où chaque ligne de la cible, munie de son propre système de transmission vers le registre de sortie dont il a été question, serait lue séparément. Cet écart est d'autant plus important, pour un standard donné, que le temps de lecture d'une ligne se trouve réduit pour des raisons diverses, telles que celles données ci-dessus dans le cas de l'infra rouge.

L'invention met à profit cette remarque pour réaliser un dispositif de lecture d'une matrice de détecteurs de rayonnement électromagnétique, dans lequel cet écart est utilisé pour appliquer aux signaux des points divers traitements de nature à améliorer l'image finale, dans les conditions qui seront décrites ci-dessous. Ces traitements sont effectués pendant le temps disponible entre l'entrée des signaux des points d'une ligne dans le dispositif de lecture et leur sortie du registre terminal.

Ces conditions seront précisées dans deux cas, celui où la cible présente une surface suffisante pour recevoir à travers le système optique approprié la totalité du champ de vision, et celui où sa surface, limitée à quelques colonnes seulement par exemple, ne lui permet d'en recevoir qu'une partie.

Dans une disposition préférée de l'invention, le dispositif de lecture, réalisé à l'état solide, utilise la technique du transfert de charges.

Selon cette technique, le transfert des charges porteuses du signal est assuré de proche en proche, d'un point au suivant d'un trajet donné, dans un substrat semi-conducteur, par polarisation séquentielle d'une série d'électrodes placées sur ce trajet. Le signal est ainsi conduit jusqu'au canal d'évacuation, par lequel tous les signaux sont transmis successivement, un par un, à l'organe de lecture proprement dit, qui peut être notamment, comme on l'a indiqué, l'écran d'un tube cathodique.

L'application de la technique du transfert de charges à la lecture de cibles, formées, comme celle à laquelle se rapporte l'invention, d'une mosaïque de détecteurs ponctuels disposés en lignes et colonnes, est en elle-même connue. Elle a donné lieu à des développements divers. On se reportera utilement à cet égard à l'article dont les références sont données ci-dessous:

"Charge coupled devices — Ted Williams Wireless World, March 1975", dans lequel sont décrits des exemples de dispositions adaptées aux fins d'une telle lecture.

L'invention sera mieux comprise en se reportant à la description qui suit et aux figures qui y sont jointes et qui représentent:

Figures 1 et 2: des vues schématiques montrant, pour deux structures de cible, l'ensemble cible, dispositif de lecture de l'invention;

Figure 3: une vue semblable à celle de la figure 1, dans une variante de l'invention incorporant un dispositif correcteur de dispersion;

Figure 4: un détail du correcteur de dispersion précédent;

Figure 5: un schéma électrique de l'entrée du dispositif de lecture des figures 1 et 2;

Figure 6: le schéma électrique d'un dispositif de multiplexage utilisé dans certaines variantes de l'invention.

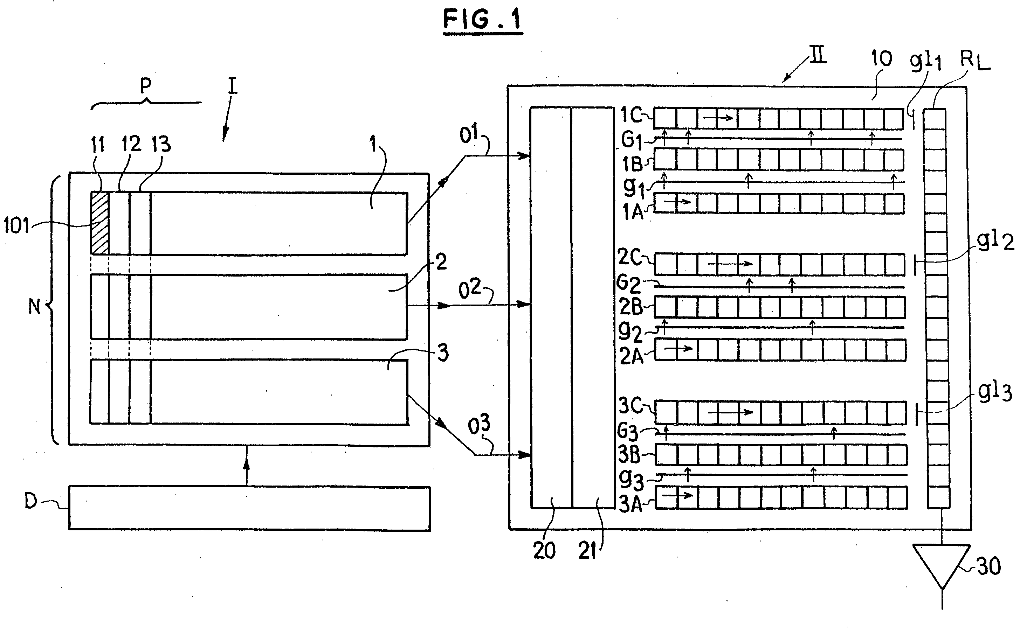

La figure 1 montre schématiquement un ensemble composé d'une cible I et du dispositif de lecture II, selon l'invention, qui lui est associé. Sur ce schéma, seules trois lignes de la cible ont été représentées, pour des raisons de simplicité, sous la forme des trois rectangles portant les repères 1, 2 et 3. La cible entière comprend en réalité N lignes et P colonnes, chacun des détecteurs de rayonnement étant placé comme dit précédemment au croisement d'une ligne et d'une colonne; trois de ces colonnes on été représentées à titre d'exemple sur le schéma, avec les repères 11, 12 et 13. Le repère 101 désigne l'un des points détecteurs de la cible, représenté par le petit rectangle couvert de hachures; les points comme les colonnes, ont été représentés jointifs dans cette vue schématique, alors qu'en réalité ils sont sans contact entre eux. Toutes les lignes sont identiques entre elles et composées de P points détecteurs élémentaires indentiques, où sont effectuées les opérations de détection et de stockage du signal constitué par des charges électriques engendrées dans les détecteurs par le rayonnement incident. Chaque ligne comporte une sortie par laquelle elle est reliée, comme l'indiquent les flèches 01, 02, 03, à la partie II de la figure, c'est-à-dire au système de lecture. Toutes les lignes sont lues en parallèle en même temps ou, ce qui revient au même, les N points d'une même colonne sont lus simultanément. Sur la figure, D représente le registre de lecture de la cible, c'est-à-dire l'ensemble des moyens électroniques de commande permettant l'adressage successif des colonnes, suivant des modalités qui dépendent de la nature des organes de prélèvement et de transfert des signaux de la cible. Ce prélèvement est avantageusement réalisé, dans le cadre de l'invention, á l'état solide, par des éléments à transfert de charges, maintenant connus de la technique sous le nom de dispositifs à transfert de charges (DTC) ou Charge Coupled Device (CCD) dans la littératude anglaise (cf.

article cité), ou par des éléments à injection de charges, CID dans la même littérature. Les N signaux des points d'une colonne de la matrice atteignent simultanément les sorties de lignes (01, 02, 03).

On appelle $t_1$ le temps nécessaire à la lecture de tous les points d'une ligne de la cible, ou temps de balayage ligne; d'après ce qui précède, c'est le temps qui sépare deux lectures successives d'une même colonne et d'un même point de chaque ligne. on désigne par $t_i$ le temps d'intégration d'un détecteur, c'est-à-dire le temps pendant lequel sont accumulées dans ce détecteur les charges électriques engendrées par le rayonnement incident dans le détecteur. Ce temps est limité à une valeur $t_s$ ($t_s > t_i$), au-delà de laquelle plus aucune accumulation n'a lieu, le détecteur étant saturé; il va sans dire que l'on fait en sorte que le temps $t_1$ soit inférieur au temps de saturation $t_s$, car dans le cas contraire, entre deus lectures du même point, la saturation du détecteur serait atteinte, et plus aucune lecture significative de la quantité de photons ayant réellement atteint ce point entre ces deux lectures ne serait possible. Il est cependant possible, même avec un temps de saturation des détecteurs inférieur au temps de balayage ligne, d'utiliser la cible en retardant un peu le déclenchement de l'intégration des charges engendrées par les photons dans les détecteurs. Quoi qu'il en soit, il reste qu'avec des temps de lecture $t_1$ faibles, on peut se permettre de choisir des temps de saturation $t_s$ faibles, c'est-à-dire, comme on l'a dit, notamment des courants d'obscurité ou de fond continu plus forts, avec les avantages que cela peut comporter pour la mise en oeuvre de la cible. Le temps d'intégration $t_i$ pourra alors être aussi voisin que possible du temps de lecture $t_1$, c'est-à-dire qu'il pourra être tenu compte dans cette intégration pratiquement de tous les photons incidents ayant atteint le détecteur entre deux lectures successives; on aura alors

$$\frac{t_i}{t_1}$$

voisin de 1, ce qui ne serait pas possible avec une cible qui ne comporterait qu'une seule sortie au lieu d'une sortie par ligne. On aura en résumé $t_i \cong t_1 < t_s$.

La partie de droite de la figure, portant le repère II, montre le dispositif de lecture de l'invention associé à la cible I. Ce dispositif est dans l'exemple constitué par une plaquette de silicium 10. Il comprend N entrées amplificatrices, une par sortie de ligne de la cible, à l'extrémité des flèches 01, 02, 03 sur la figure, dont l'ensemble est représenté par le rectangle portant le repère 20. Dans ces entrées, sont intégrés par exemple les circuits électriques permettant la polarisation en inverse, á un potentiel de référence $V_r$, de diodes ou de structures MIS (métal isolant semi-conducteur), par exemple formées dans le silicium. Le dispositif comporte également N entrées de dispositifs à transfert de charges dont l'ensemble porte le repère 21; chacune de ces dernières entrées assure l'injection des signaux dans un canal à transfert de charges, noté 1A pour la ligne 1, noté 2A pour la ligne 2 et 3A pour la ligne 3 de la cible de l'exemple.

Chaque canal A permet de stocker les signaux des P points d'une ligne de la cible dans P éléments de stockage représentés schématiquement par les petits carrés jointifs alignés horizontalement. Chacun de ces carrés représente une cellule du canal à transfert de charges, connu de l'art, sur lesquelles on ne s'étendra pas. On sait que le transfert de cellule à cellule se fait dans un tel canal par le moyen de grilles en nombre égal au nombre de phases utilisées pour ce transfert, auxquelles sont appliquées les polarisations nécessaires avec la phase voulue. Les N canaux de type A, tels que 1A, 2A, 3A, sont remplis simultanément par transfert des charges de proche en proche d'un carré au suivant grâce à un système commun de commutation des phases, en synchronisme avec la lecture des colonnes de la cible. Ce transfert le long des canaux est schématisé par les flèches à l'intérieur des rectangles 1A, 2A, 3A. Le transfert complet de l'extrémité de gauche à celle de droite du canal est réalisé dans le temps de ligne $t_1$ précédent; au bout de ce temps se trouvent transférés dans ce canal les signaux de tous les détecteurs de la ligne correspondante de la cible, avec un temps d'intégration $t_i$. Après remplissage des canaux de type A (1A, 2A, 3A) les charges accumulées sont transférées, par commutation simultanée des grilles de transfert $g_1$, $g_2$, $g_3$, dans d'autres canaux à transfert de charges de type B, repérés 1B, 2B, 3B sur le dessing, comportant le même nombre P d'éléments que ceux de type A, représentés eux aussi par les petits carrés jointifs.

Le transfert de charges des canaux A aux canaux B se fait d'un élément du canal A à celui situé vis-à-vis dans le canal B, comme l'indiquent les petities flèches verticales entre ces canaux. Ce transfert est répété plusieurs fois avec un temps de récurrence égal au temps de ligne $t_1$. On procède ainsi dans le dispositif de l'invention à des accumulations successives des signaux d'un point de la cible. Après ces accumulations, les charges ainsi stockées dans les éléments de type B sont transférées dans des canaux de type C, repérés 1C pour la ligne 1 et 2C et 3C pour les deux autres lignes, d'un élément à celui lui faisant vis-à-vis (flèches verticales) par commutation simultanée des grilles de transfert $G_1$, $G_2$, $G_3$. Les charges accumulées dans les canaux C sont ensuite évacuées vers le registre de lecture $R_L$, par transfert longitudinal comme l'indiquent les petites flèches horizontales à l'intérieur des canaux de type C. Ce dernier transfert se fait à une cadence plus faible que la cadence de transfert dans les canaux A; il est assuré par commutation simultanée des grilles de transfert de toutes les lignes, repérées $gl_1$, $gl_2$, $gl_3$ pour les trois lignes du dessin. Le registre $R_L$ est dans l'exemple un registre à transfert de charges comme les canaux précédement décrits, dont les cellules sont également représentées par de petits carrés. Il est vidé par transfert de charges de proche en proche vers l'amplificateur 30; cet amplificateur est un amplificateur vidéo dans le cas où la destination du dispositif est la réception de télévision. Il est lui-même réalisé sous forme intégrée dans le substrat de silicium 10 et relié à l'appareil de lecture non représenté. Le registre $R_L$ est vidé en un temps $t_1$ des signaux d'une ligne, de télévision dans l'exemple. On notera que cette ligne est formée des points d'une colonne de la cible. A la fin de chaque lecture du registre, et donc avec un temps de récurrence égal à $t_1$, les charges accumulées dans les cellules des canaux de type C subissent un transfert dans le sens des flèches figurant dans ces canaux qui les amène dans la cellule suivante du canal, et les grilles $gl_1$, $gl_2$, $gl_3$ sont de nouveau commutées simultanément pour permettre le transfert du canal C au registre $R_L$.

Dans la description qui vient d'être faite et qui correspond au cas où les N lignes et P colonnes de la cible sont en nombre suffisant pour recevoir le rayonnement incident en provenance de la totalité du champ de l'image à visualiser, correspondant à $N = P = 500$ par exemple, les charges signal accumulées dans les canaux A sont transférées avec un temps de récurrence $t_1$ dans les canaux B et accumulées dans ces canaux pendant un temps total que l'on appellera $T_i$, qui peut être de l'ordre du temps $T_t$, nécessaire à la lecture de la totalité d'un canal C et de tous ses semblables. Ce temps n'est autre que le temps de trame dans le cas où l'amplificateur vidéo 30 alimente un récepteur de télévision, comme on l'a supposé dans l'exemple, c'est-à-dire le temps de lecture d'une image complète du standard adopté, de l'ordre de plusieurs dizaines de millisecondes. Le temps $T_i$ précédent, ajustable, est le temps d'intégration des points de la trame de télévision. Il est très supérieur au temps $t_i$ défini précédemment pour la cible. Dans les canaux B du dispositif de l'invention, les charges provenant des détecteurs de la cible sont donc accumulées pendant un temps $T_i$ au cours duquel ont lieu les intégrations successives dont il a été question à propos de ces canaux, et stockées pendant un temps total $T_t$. A la fin d'une trame, quand les canaux C ont été complètement vidés dans le registre $R_L$ de lecture, les charges contenues dans les canaux B sont transférées dans les canaux C où elles sont lues en un temps de trame $T_t$, et ainsi de suite. Le dispositif de lecture II assure donc la conversion parallèle entre les N entrées, 01, 02, 03 … et la sortie unique du registre $R_L$ vers l'amplificateur 30. Il permet une intégration pendant le

temps $T_i$ de l'ordre de $T_t$, et donc pendant un temps très supérieur au temps d'intégration $t_i$ de la cible elle-même; le dispositif joue le rôle d'intégrateur de trame et assure de ce fait une amélioration sensible du rapport signal sur bruit. Bien entendu, ce résultat ne peut être atteint qu'avec des substrates (plaquette 10) présentant eux-mêmes un courant d'obscurité faible, permettant sans inconvénient de telles intégrations; c'est effectivement le cas pour les plaquettes de silicium dont on dispose actuellement, dont les courants d'obscurité sont beaucoup plus faibles que ceux des matériaux de cible; ces derniers sont, on le rappelle, notamment le tellurure de plomb, de plomb et d'étain, etc.

Le dispositif permet aussi la conversion de standard du fait des temps de stockage entre les canaux A et C; il permet d'adapter le temps de trame à celui d'un standard usuel.

Le même dispositif permet aussi la prise de vues dans un deuxième cas, celui où la surface de la cible, trop petite, ne peut recevoir qu'une partie de l'image à reproduire. On supposera que cette cible comporte N lignes, comme la précédente, mais seulement quelques colonnes, à savoir p colonnes, au lieu du nombre P précédent (p inférieur à P). Ces N lignes couvrent, comme dans le cas précédent, le champ de l'image reçue, à travers le système optique placé devant la cible, dans l'une de ses dimensions, les p colonnes ne le couvrant qu'en partie dans l'autre.

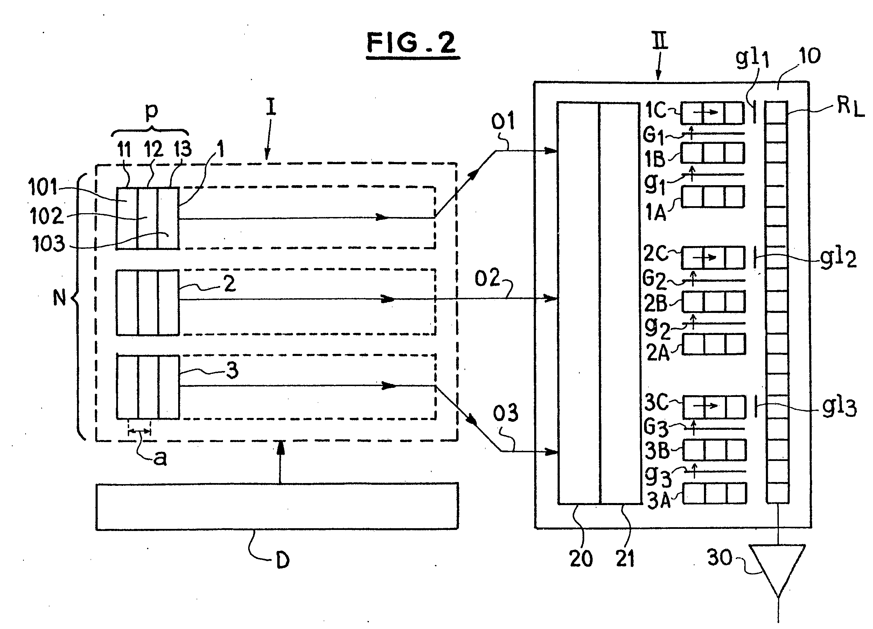

La cible se présenterait alors, comme le montre la figure 2, avec les N lignes de l'exemple précédent, dont seules trois ont été représentées comme sur la figure 1; la cible comporte trois colonnes seulement (p = 3), cette fois; ce nombre de trois n'a pas été choisi pour simplifier la représentation mais parce que, effectivement, la cible n'en comporte que trois. En pointillé, on a représenté sur le dessin de la figure 2 les contours qui devraient être ceux de la partie I pour qu'elle couvre tout le champ de vision; ces contours sont les mêmes que ceux de la figure 1. Quant à la partie II, ses canaux 1A, 1B, 1C, 2A, . . . , comme on le verra par ce qui suit, comportent chacun trois cellules. Dans le cas de la figure 2, on conçoit qu'un déplacement relatif de la cible par rapport à l'image incidente puisse permettre d'envoyer successivement sur le nombre limité de colonnes de la cible toutes les portions de l'image incidente. Ce déplacement relatif peut être réalisé soit par déplacement de la cible par rapport à l'optique à travers laquelle est transmise l'image, soit par déplacement de l'image par rapport à la cible maintenue fixe; la solution adoptée est sans importance dans le cadre de l'invention; dans les deux situations, cependant, ce déplacement a lieu parallèlement à la direction des lignes de manière à amener successivement toutes les portions de l'image sur les trois colonnes de la cible. Dans l'une comme dans l'autre de ces situations, on continuera d'ailleurs à parler de ligne de l'image, bien que comme il ressort des hypothèses caractérisant ce deuxième cas, les lignes de la cible soient incomplètes.

Les lignes de l'image dont il sera question sont alors toute simplement celles des lignes dont il a été question dans le cas de la figure 1 et dont la longueur couvrait toute la dimension de l'image perpendiculaire aux colonnes. La projection de l'image sur la cible défilera sur les colonnes 11, 12, 13 de la gauche vers la droite de la figure par exemple, dans la direction perpendiculaire aux colonnes de cette figure. Son déplacement se fera à une vitesse constante que l'on désignera par v; les points de ces colonnes appartenant à la première ligne sont repérés 101, 102 et 103 sur la figure 2. On voit que, dans ces conditions, un point donné de l'image qui se trouve à un instant donné t sur un point 101 de la colonne 11 de la cible, c'est-à-dire sur le détecteur placé en ce point, se trouve sur le point 102 de la colonne 12 situé sur la même ligne après un temps

$$\tau = \frac{a}{v},$$

si l'on désigne par $a$ le bas, constant, des colonnes de la cible, c'est-à-dire la distance entre deux détecteurs successifs d'une même ligne; il se trouve sur le point 103 de la colonne 13 qui le suit sur la même ligne au bout du temps

$$2\tau = \frac{2a}{v}.$$

L'addition de ces trois signaux, donnés par les détecteurs 101, 102, 103 pour un même point de l'image, améliore le rapport signal/bruit de ce point de l'image. Mais cette addition doit se faire en tenant compte des dephasages indiqués $\tau$ et $2\tau$ entre ces signaux. On doit pour cela appliquer à chacun d'eux le retard nécessaire pour le replacer en phase avec le précédent. Le dispositif à semiconducteur II de l'invention permet précisément d'assurer ces opérations de retard et d'additionner les signaux des trois points de la ligne de la cible (et de ses colonnes).

A cet effet, après que les charges engendrées dans les trois détecteurs d'une ligne, tels que 101, 102, 103 ont été transférées dans les canaux A (1A pour la ligne supérieure de la cible sur le dessin) en un temps égal au temps $t_1$ de lecture d'une ligne de la cible, par polarisation des grilles g comme dans le cas précédent, elles sont transférées dans les canaux B (1B pour la ligne en question) avec un temps de récurrence $t_1$ et accumulées dans ces canaux pendant un temps égal à $\tau$. Ce temps d'intégration $\tau$ peut être égal à $T_i$ défini ci-dessus. Elles sont alors transférées dans les canaux de type C, 1C pour la ligne en question, par action sur les grilles G, avec un temps de récurrence $\tau$. En même temps, les charges dans les canaux C sont décalées d'une cellule à la suivante vers la sortie, dans la direction du registre $R_L$. Cette opération revient bien à additionner au signal d'un point donné de la cible celui de la colonne précédente retardé de $\tau$, c'est-à-dire à additionner ces deux signaux en phase. On répète l'opération pour la colonne qui précède cette dernière.

On procède de la même façon simultanément pour toutes les lignes de la cible, lues en parallèle comme indiqué précédemment.

A la fin de ces transferts, dans la dernière cellule des canaux C, celle la plus proche du registre $R_L$, est stocké pour chaque ligne le signal correspondant à la somme des signaux des détecteurs de toutes les colonnes de la cible: trois dans l'exemple, où les canaux A, B, C comportent pour cette raison chacun trois cellules. Ce signal est transféré alors dans le register $R_L$ en un temps inférieur ou égal à $\tau$. On a dit que ce temps $\tau$ peut être égal à $T_i$, temps d'intégration de la trame du standard de l'image alimentée par l'amplificateur 30, très supérieur au temps $t_1$ de lecture d'une ligne de la cible. Il peut être aussi sensiblement plus faible et égal précisément à ce temps $t_1$. Dans ce cas, on notera que les accumulations successives dans les canaux B deviennent inutiles; les charges signal sont alors directement transférées des canaux A dans les canaux C, sans stockage dans les canaux B, par application successive des potentiels nécessaires aux grilles g et G. Le temps de retard $\tau$ peut être ajusté pratiquement de façon continue entre les temps $t_1$ et $T_i$, et même $T_t$, temps de trame de l'image finale, par variation de la vitesse de déplacement relatif v. Ceci est l'un des avantages de l'invention par rapport aux dispositifs de lecture connus disposant d'une seule sortie sur la cible et dans lesquels le retard $\tau$ serait nécessairement égal au temps de trame $T_t$, et qui présentent de ce fait une moindre souplesse d'utilisation.

On a décrit ci-dessus comment se ferait l'addition en phase des signaux d'une ligne, dans le cas d'une cible incomplète, au sein du dispositif II. Il va sans dire que ce traitement s'applique aussi au moyen du dispositif II au cas d'une cible complète. Ce cas correspondrait à celui d'une cible complète utilisée pour une surveillance panoramique.

Dans ce qui suit, est décrite une possibilité supplémentaire du dispositif de lecture de l'invention, applicable aux deux cas envisagés plus haut, à savoir celui de la cible complète et celui de la cible réduite à quelques colonnes. Cette possibilité concerne un traitement du signal permettant une correction partielle de la dispersion entre les réponses des différents détecteurs composant la cible à un rayonnement incident uniforme; cette dispersion est un fait constant dans la réalisation des cibles de prise de vues.

Une telle correction partielle peut s'avérer suffisante dans le cas de l'addition en phase des p colonnes, c'est-à-dire le deuxième cas envisagé, où cette dispersion des réponses est déjà divisée par $\sqrt{p}$ par rapport au cas sans addition des colonnes.

Ce traitement consiste à retrancher au signal de chaque détecteur le signal engendré dans le même détecteur par un rayonnement incident fixe. On formera la différence Sij — Sijl, dans laquelle Sij désigne le signal du détecteur (ligne i, colonne j) sous l'effet du rayonnement incident de l'image, et Sijl celui du même détecteur sous un rayonnement donné $H_1$, le même pour tous les détecteurs. Ce traitement nécessite l'adjonction à l'ensemble cible, dispositif de lecture (I, II) des figures 1 et 2, d'un troisième élément à mémoire dans lequel sont stockés les signaux Sijl.

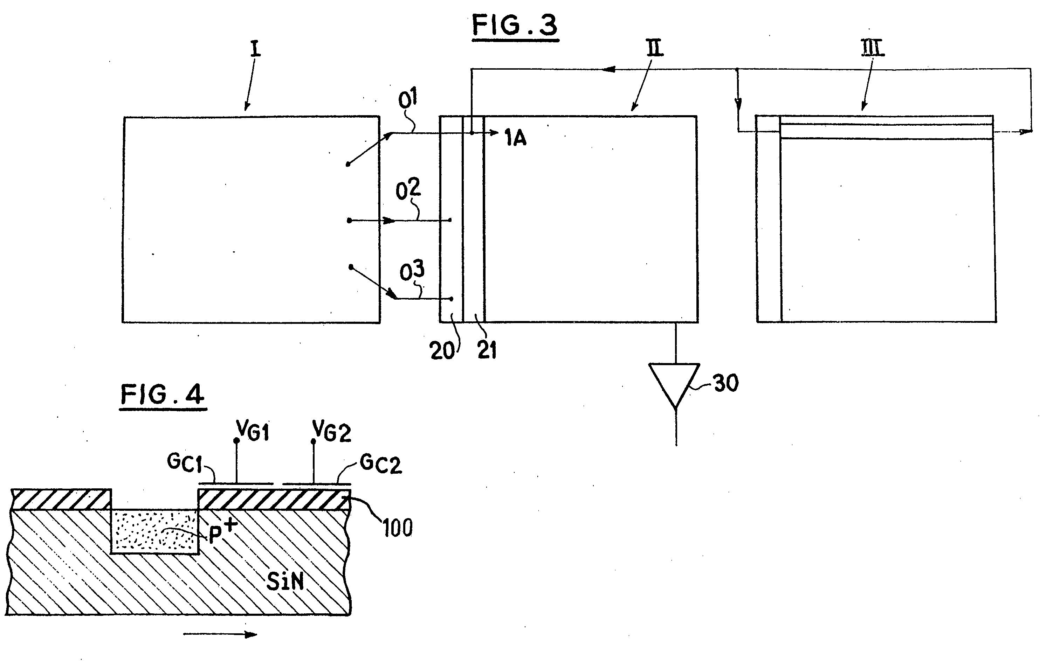

La figure 3 montre un tel ensemble.

La mémoire III en question est dans l'exemple une mémoire circulante à N lignes, à P cellules chacune soit N x P bits, qui peut être "rafraîchie" périodiquement par introduction de nouveaux signaux Sijl engendrés à intervalles réguliers par exposition de la cible au rayonnement incident uniforme $H_1$. La différence Sij — Sijl est formée au niveau des entrées du dispositif de lecture II. Comme illustré sur la figure 3, les informations des N lignes de la mémoire sont extraites de la mémoire en synchronisme avec l'injection de lignes de la cible dans les canaux A du dispositif de lecture II et réinjectées dans ce canaux. La flèche verticale entre les parties II et III symbolise l'entrée des signaux Sijl dans la mémoire; on s'est limité à une ligne de cette mémoire dans la représentation de la figure et on a volontairement omis la représentation détaillée des parties I et II qui est la même que celle de la figure 1.

La figure 4 donne, pour fixer les idées, un exemple de réalisation de l'injection des différences Sij — Sijl dans les canaux A, dans le cas où le dispositif de lecture II utilise des cellules à transfert de charges formées dans le substrat de silicium 10, comme il en a déjà été question plus haut. La figure représente l'entrée d'une ligne du dispositif de lecture. La diffusion $p^+$ dans le substrat de silicium de type N (SiN) est dans un premier temps polarisée en direct pour remplir les puits de potentiel sous les grilles GC1 et GC2, appliquées sur l'isolant 100. Elle est ensuite polarisée en inverse en même temps que le signal Sij est appliqué à la grille GC2 et le signal Sijl à la grille GC1. La charge restant sous la grille GC2 après équilibration des deux potentiels à l'interface isolant semi-conducteur sous les grilles $VG_1$ et $VG_2$ est alors proportionnelle à Sij — Sijl. Cette charge est ensuite transférée dans le canal A correspondant dans la direction de la flèche.

L'opération Sij — Sijl effectuée à l'entrée du dispositif de lecture revient à un ébasage du signal Sij par soustraction d'une partie du fond continu engendré par le rayonnement ambiant. Cette réduction du signal Sij permet, toutes choses égales par ailleurs, un plus grand nombre d'accumulations successives dans les canaux B, c'est-à-dire un temps d'intégration $T_i$ dans le dispositif de lecture plus élevé, et donc un meilleur rapport signal sur bruit.

Il ressort de ce qui précède que le dispositif de l'invention permet d'assurer diverses fonctions dans le traitement du signal de la cible qui lui est associée par des transferts en série, parallèle et série, comme exposé ci-dessus.

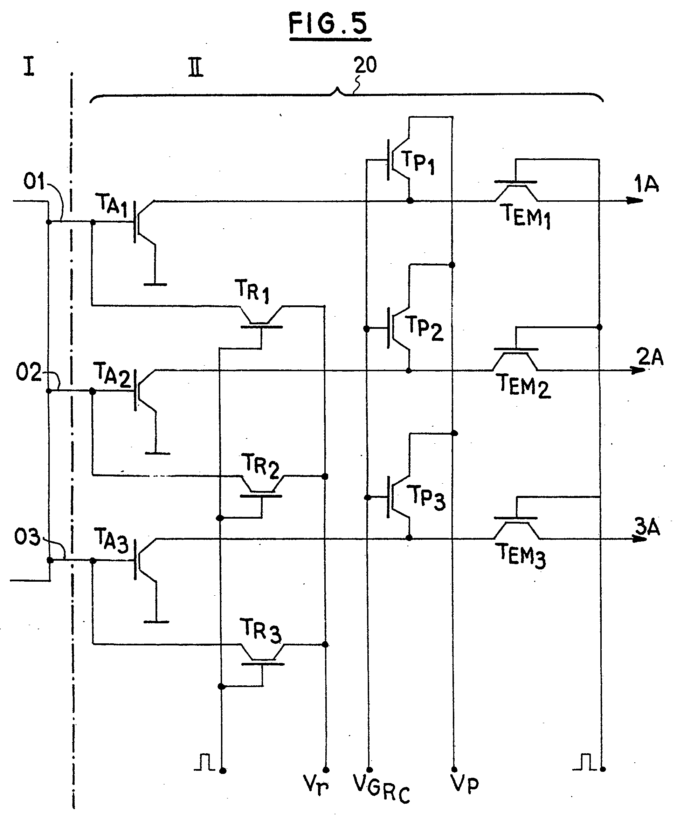

La figure 5, où les mêmes repères désignent les mêmes éléments que dans les figures précédentes, schématise un exemple de structure de l'entrée du dispositif II de lecture, utilisant la technologie Métal, Oxyde, Semi-conducteur (MOS). Sur cette figure $T_{A1}$, $TA_2$, $T_{A3}$ sont les transistors d'amplification et les transistors $T_{P1}$, $T_{P2}$, et $T_{P3}$ des transistors utilisés comme résistances de charge: leur résistance de canal polarisée par le tension $V_p$ est modulée par la tension de grille $V_{GRC}$. Les transistors $T_{R1}$, $T_{R2}$, $T_{R3}$ assurent la remise à zéro: dans l'état passant au moment de l'impulsion de grille, ils ramènent les sorties de la cible au potentiel de référence $V_r$ avant la lecture de chaque colonne. Enfin, sur cette figure en $T_{EM1}$, $T_{EM2}$ et $T_{EM3}$ sont représentés des transistors d'échantillonnage et de maintien rendus passants par l'impulsion d'échantillonnage au moment de la lecture de chaque colonne, et qui sont dans l'état bloquant le reste du temps, pour maintenir la tension lue du côté de l'entrée des canaux de transfert. Sur la figure, les flèches de droite sont dirigées vers ces entrées, c'est-à-dire les canaux de type A.

Enfin, on a décrit ci-dessus l'invention, en admettant que la cible comportait une sortie par ligne de détecteurs, et le dispositif de lecture autant d'entrées, reliées chacune à l'une des sorties précédentes. L'invention s'applique tout aussi bien au cas où plusieurs lignes de détecteurs (n lignes; n sous multiple de N) de la cible seraient groupées ensemble de façon à ne comporter qu'une seule sortie commune. La seule différence avec le cas décrit dans ce qui précède serait que chaque détecteur de la cible ne serait relu qu'au bout du temps $nt_1$ (au lieu de $t_1$), $t_1$ désignant toujours la durée de lecture d'une ligne de la cible; la limite du temps d'intégration $t_i$ dans la cible serait dans ce cas $nt_1$ elle aussi.

Le dispositif de lecture, lui, continuerait, comme dans les exemples décrits, à comporter N entrées, un système de multiplexage permettant d'adresser dans les canaux du dispositif de lecture successivement chacune des lignes de la cible.

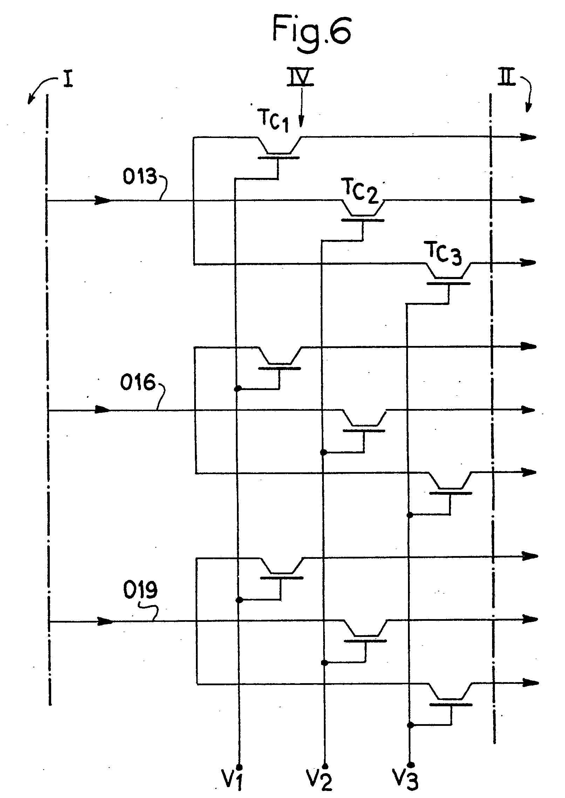

La figure 6 représente schématiquement un exemple de réalisation du système de multiplexage IV, pour n = 3; la cible est supposée comporter trois tels groupes, c'est-à-dire neuf lignes. Dans chacun de ces groupes, les transistors tels que $TC_1$ sont maintenus dans l'état passant pendant que les deux autres sont dans l'état bloquant par les tensions $V_1$, $V_2$, $V_3$, ces états se succédant de l'un à l'autre par permutation circulaire. Les sorties de la cible sont notées 013, 016 et 019, à chacune desquelles correspondent trois entrées dans les canaux de type A du dispositif de lecture. Ces entrées se font suivant les flèches de droite de la figure, vers les canaux 1A, 2A, et 3A des figures précédentes pour les trois premières lignes de la cible, c'est-à-dire pour le groupe 013. Dans chaque groupe, après injection des signaux de la première ligne dans le dispositif de lecture, la deuxième ligne est injectée, puis la troisième puis de nouveau la première et ainsi de suite. Le cas d'une cible à N/n sorties groupant chacune n lignes se présente en particulier quand la matrice à N x P éléments détecteurs est réalisée au moyen de N/n modules surfaciques de n x P éléments ne comportant chacun qu'une seule sortie.

Il va sans dire que sont compris dans l'invention les ensembles comportant à la fois le dispositif de correction III et le système de multiplexage IV représentés sur les figures 3 et 6 respectivement et ce, aussi bien dans le cas des cibles à N lignes et P colonnes de la figure 1, que dans celui des cibles à p colonnes seulement de la figure 2.

**Revendications**

1. Dispositif de lecture d'une cible de prise de vues composée d'une matrice de détecteurs ponctuels, ou points de la cible, disposés aux points de croisée de N lignes et P colonnes rectangulaires, exposés au rayonnement en provenance de champ image et fournissant un signal électrique sous l'effet de celui-ci, caractérisé en ce qu'il comporte une entrée par ligne de la cible et un registre de sortie ne comportant qu'une seule sortie reliée à l'entrée d'un appareil de lecture, et en ce qu'il comporte pour chaque ligne, disposés entre ces entrées et ce registre, des moyens assurant simultanément pour toutes ces lignes:

a) la réception dans des canaux A des signaux des détecteurs de la ligne dans l'ordre d'adressage choisi, et le transfert le long de ces canaux dans un temps $t_1$ dit temps de lecture de ligne de cible;

b) Le transfert en parallèle de ces signaux dans des organes de stockage B avec un temps de récurrence égal au temps de lecture $t_1$ de la ligne;

c) le transfert en parallèle des signaux stockés dans les canaux B dans des canaux d'évacuation C avec le même temps de récurrence $t_1$;

d) le transfert en série de ces signaux le long de ces canaux d'évacuation C;

e) le transfert de ces signaux dans le registre de sortie, le temps d'évacuation de la totalité des signaux reçus par le registre de sortie étant égal à celui de la lecture d'une vue dans l'appareil de lecture, et éventuellement.

f) des moyens pour faire avancer les signaux d'un rang vers le registre de sortie entre deux transferts successifs des signaux des canaux de stockage B dans les canaux d'évacuation C.

2. Dispositif suivant la revendication 1, caractérisé en ce que lesdits moyens (a) à (f) sont des dispositifs à transfert de charges réalisés dans un substrat de silicium.

3. Ensemble formé par une cible de prise de vues et par son dispositif de lecture, dans lequel lesdits détecteurs ponctuels occupent sur celle-ci toute la surface atteinte par le rayonnement incident en provenance du champ image, caractérisé en ce que le dispositif de lecture est un dispositif suivant la revendication 1 comprenant les moyens (a), (b), (c), (d), et (e).

4. Ensemble formé par une cible de prise de vues et par son dispositif de lecture, dans lequel lesdits détecteurs ponctuels occupent sur celle-ci, dans la direction des lignes, une partie seulement de la surface atteinte par le rayonnement incident en provenance du champ image, c'est-à-dire un nombre de colonnes inférieur à celui qui serait nécessaire pour couvrir toute la surface atteinte dans le plan de la cible par le rayonnement incident en provenance du champ image, caractérisé en ce que le dispositif de lecture est un dispositif suivant la revendication 1, comprenant les moyens (a), (b), (c), (d), (e) et (f).

5. Ensemble suivant la revendication 3, caractérisé en ce que, avant le transfert dans les canaux d'évacuation C, les transferts dans les canaux B sont répétés pendant tout ou partie du temps nécessaire à l'évacuation complète des canaux C, lesdits transferts répétés assurant l'intégration dans ces canaux des signaux reçus par chaque détecteur pendant ce temps.

6. Ensemble suivant la revendication 4, dans lequel la cible et le champ image sont soumis à un déplacement relatif dans la direction perpendiculaire aux colonnes avec une vitesse constante v, de façon à amener par tranches successives le rayonnement incident en provenance du champ image sur lesdites colonnes, a désignant le pas de ces colonnes, c'est-à-dire la distance séparant deux détecteurs successifs d'une même ligne, caractérisé en ce que le transfert par les moyens (c) dans les canaux d'évacuation a lieu avec un temps de récurrence $\tau$ égal à

$$\frac{a}{v} \quad (\tau = \frac{a}{v}),$$

c'est-à-dire le temps nécessaire à un point de l'image pour passer dans ce déplacement relatif d'une colonne à la colonne suivante, et caractérisé en ce que ledit transfert dans le registre de sortie a lieu avec le même temps de récurrence $\tau$ , ledit ensemble assurant l'addition en phase des signaux du même point de l'image reçus par les détecteurs d'une même ligne au cours de ce déplacement relatif.

7. Ensemble suivant la revendication 6, caractérisé en ce que le temps $\tau$ est ajusté à une valeur très supérieure à $t_1$, ledit ensemble assurant l'intégration des signaux reçus par chaque détecteur pendant ce temps.

8. Ensemble suivant la revendication 5, caractérisé en ce que ledit appareil de lecture étant un écran récepteur de télévision, le temps d'évacuation des canaux C est égal au temps de trame $T_t$ de l'image donnée par ce récepteur.

9. Ensemble suivant la revendication 7, caractérisé en ce que ledit appareil de lecture étant un écran récepteur de télévision, le temps $\tau$ est égal au temps d'intégration de l'image dans ce récepteur.

10. Ensemble suivant la revendication 6, caractérisé en ce que le temps $\tau$ est égal sensiblement au temps $t_1$ et en ce que le transfert des canaux A vers les canaux C a lieu directement sans passage dans les canaux B.

11. Ensemble suivant l'une des revendications 3, ou 4, caractérisé en ce qu'il comprend en outre une mémoire circulante dont les bits sont disposés comme les détecteurs de la cible aux points de croisée de lignes et colonnes, dans lesquels bits sont stockés les signaux fournis par les détecteurs de la cible sous l'effet d'un rayonnement incident uniforme, ladite mémoire étant pourvue de moyens pour extraire ces derniers signaux en synchronisme avec ceux correspondants des détecteurs de la cible, des moyens pour faire la différence entre eux et des moyens pour injecter ces différences dans le dispositif de lecture.

12. Ensemble suivant la revendication 3 ou la revendication 4, caractérisé en ce que ladite cible comporte une sortie par ligne.

13. Ensemble suivant la revendication 3 ou la revendication 4, caractérisé en ce que ladite cible comporte une sortie par groupe de n lignes successives, n étant un nombre entier sous-multiple du nombre N de lignes de la cible et en ce qu'il comporte en outre, disposé entre la cible et le dispositif de lecture, un système de multiplexage assurant le transfert ligne par ligne des signaux de chaque groupe dans l'une des entrées du dispositif de lecture.

**Claims**

1. Reading device for an image-receiving target comprising a matrix of punctiform detectors or target dots which are disposed at intersections of rows and columns perpendicular to each other and exposed to radiation originating from the image field and furnish under the influence thereof an electrical signal, characterised by an input per row of the target, an output register having only one output connected to the input of a reading means and means for each row which are inserted between said inputs and said register and permit the following simultaneously for all of these rows.

a) the receipt of detector signals of the row in channels A in the selected address sequence and the transfer along said channels in a time $t_1$, the target row reading time;

b) the parallel transfer of said signals into storage means B having a recurrence time which is equal to the row reading time $t_1$;

c) The parallel transfer of the signals stores in the channels B into discharge channels C with the same recurrence time $t_1$;

d) the serial transfer of said signals along the discharge channels C;

e) the transfer of said signals into the output register, the discharge time of all the signals received by the output register being equal to the image reading time in the reading means, and possibly;

f) means for advancing the signals by one location in the direction to the output register between two successive transfers of signals from the storage channels B into the discharge channels C.

2. Device according to claim 1, characterized in that the means (a) to (f) are charge transfer means which are formed in a silicon substrate.

3. Arrangement comprising an image-receiving target and its reading device in which the punctiform detectors occupy on the target the entire area reached by the incident radiation originating from the image field, characterized in that the reading device is a device according to claim 1 with the means (a), (b), (c), (d) and (e).

4. Arrangement comprising an image-receiving target and its reading device in which the punctiform detectors occupy on the target in the direction of rows only a part of the area reached by the incident radiation originating from the image field, i.e. a number of columns which is smaller than that which would be necessary to cover the entire area in the target plane reached by the incident radiation originating from the image field, characterized in that the reading device is a device according to claim 1 with the means (a), (b), (c), (d), (e) and (f).

5. Arrangement according to claim 3, characterized in that prior to the transfer into the discharge channels C the transfers into the channels B are repeated during the entire time or a part of the time which is necessary for complete emptying of the channels C, the repeated transfers ensuring the integration of the signals received by each detector during this time in said channels.

6. Arrangement according to claim 4 in which the target and the image field are subjected to a relative displacement in the direction perpendicular to the columns with a constant speed v so that the incident radiation originating from the image field is conducted in successive portions to the columns, a designating the interval of the columns, i.e. the distance between two successive detectors of the same row, characterized in that the transfer takes place with the aid of the means (c) into the discharge channels with a recurrence time $\tau$ which is equal to

$$\frac{a}{v} \left( \tau = \frac{a}{v} \right),$$

i.e. equal to the time which an image dot requries to pass from one column to the next column during this relative displacement, and that the transfer to the output register takes place with the same recurrence time $\tau$, the arrangement ensuring the equal-phase addition of the signals from the same point of the image received by the detectors in the same row in the course of said relative displacement.

7. Arrangement according to claim 6, characterized in that the recurrence time $\tau$ is set to a value far greater than $t_1$, the arrangement ensuring the integration of the signals received by each dector during said time.

8. Arrangement according to claim 5, characterized in that the reading means is a television receiver screen and that the discharge time of the channels C is equal to the frame period $T_t$ of the image furnished by said receiver.

9. Arrangement according to claim 7, characterized in that the reading means is a television receiver screen and that the recurrence time $\tau$ is equal to the integration time of the image in said receiver.

10. Arrangement according to claim 6, characterized in that the recurrence time $\tau$ is substantially equal to the time $t_1$ and that the transfer from the channels A to the channels C takes place directly without passage through the channels B.

11. Arrangement according to claim 3 or 4, characterized by a circulating memory whose bits are disposed like the detectors of the target at intersections of rows and columns, the signals furnished by the detectors of the target under the influence of a uniform incident radiation being stored in said bits and means being provided in the memory for extracting said latter signals synchronously with the signals corresponding to the detectors of the target, means being provided for forming the difference between said signals as well as means for feeding said differences into the reading device.

12. Arrangement according to claim 3 or 4, characterized in that the target has one output per row.

13. Arrangement according to claim 3 or 4, characterized in that the target comprises an output per group of n successive rows, n being an integer submultiple of the number N of the rows of the target, and that a multiplexing system is provided between the target and the reading device and ensures the row-wise transfer of the signals of each group into one of the inputs of the reading device.

## Patentansprüche

1. Lesevorrichtung für ein Bildaufnahme-Target mit einer Matrix aus punktförmigen Detektoren oder Targetpunkten, die an Schnittpunkten von rechtwinklig zueinander verlaufenden Zeilen und Spalten angeordnet und einer vom Bildfeld ausgehenden Strahlung ausgesetzt sind und unter deren Einfluß ein elektrisches Signal liefern, gekennzeichnet durch einen Eingang pro Zeile des Targets, ein Ausgangsregister mit nur einem mit dem Eingang eines Lesegeräts verbundenen Ausgang und Mittel für jede Zeile, die zwischen diese Eingänge und dieses Register eingefügt sind und gleichzeitig für alle diese Zeilen folgendes ermöglichen:

a) den Empfang von Detektorsignalen der Zeile in Kanälen A in der gewählten Adressierungsreihenfolge und die Übertragung längs dieser Kanäle in einer Zeit $t_1$, der Target-Zeilenlesezeit;

b) die parallele Übertragung dieser Signale in Speicherorgane B mit einer Folgeperiode, die gleich der Zeilenlesezeit $t_1$ ist;

c) die parallele Übertragung der in den Kanälen B abgespeicherten Signale in Abgabekanäle C mit der gleichen Folgeperiode $t_1$;

d) die serielle Übertragung dieser Signale längs der Abgabekanäle C;

e) die Übertragung dieser Signale in das Ausgangsregister, wobei die Abgabezeit aller von dem Ausgangsregister empfangenen Signale gleich der Bildlesezeit im Lesegerät ist, und gegebenenfalls,

f) Mittel zum Vorwärtsbewegen der Signale um eine Stelle in Richtung zum Ausgangsregister zwischen zwei aufeinanderfolgenden Übertragungen von Signalen aus den Speicherkanälen B in die Ausgabekanäle C.

2. Vorrichtung nach Anspruch 1, dadurch gekennzeichnet, daß die Mittel (a) bis (f) Ladungsübertragungsvorrichtungen sind, die in einem Siliciumsubstrat verwirklicht sind.

3. Anordung aus einem Bildaufnahme-Target und seiner Lesevorrichtung, in der die punktförmigen Detektoren auf dem Target die ganze von der vom Bildfeld kommenden einfallenden Strahlung erreichte Fläche einnehmen, dadurch gekennzeichnet, daß die Lesevorrichtung eine Vorrichtung nach Anspruch 1 mit den Mitteln (a), (b), (c), (d) und (e) ist.

4. Anordnung aus einem Bildaufnahme-Target und seiner Lesvorrichtung, in der die punktförmigen Detektoren auf dem Target in Richtung von Zeilen nur einen Teil der von der vom Bildfeld kommenden einfallenden Strahlung erreichten Fläche einnehmen, d.h. eine Anzahl von Spalten, die kleiner als die ist, die zur Bedeckung der gesamten von der vom Bildfeld kommenden einfallenden Strahlung erreichten Fläche in der Targetbene notwendig wäre, dadurch gekennzeichnet, daß die Lesvorrichtung eine Vorrichtung nach Anspruch 1 mit den Mitteln (a), (b), (c), (d), (e) und (f) ist.

5. Anordnung nach Anspruch 3, dadurch gekennzeichnet, daß vor der Übertragung in die Abgabekanäle C die Übertragungen in die Kanäle B während der gesamten Zeit oder eines Teils der Zeit wiederholt werden, die zur vollständigen Entleerung der Kanäle C erforderlich ist, wobei die wiederholten Übertragungen die Integration der von jedem Detektor während dieser Zeit empfangenen Signale in diesen Kanälen gewährleisten.

6. Anordnung nach Anspruch 4, in der das Target und das Bildfeld einer Relativverschiebung in der zu den Spalten senkrechten Richtung mit einer konstanten Geschwindigkeit v unterzogen werden, so daß die vom Bildfeld kommende einfallende Strahlung in aufeinanderfolgenden Abschnitten zu den Spalten geführt wird, wobei a die Schrittweite der Spalten bezeichnet, d.h. den Abstand zwischen zwei aufeinanderfolgenden Detektoren der gleichen Zeile, dadurch gekennzeichnet, daß die Übertragung mit Hilfe der Mittel (c) in die Abgabekanäle mit einer Folgeperiod $\tau$ stattfindet, die gleich

$$\frac{a}{v} \text{ ist } (\tau = \frac{a}{v}),$$

d.h. gleich der Zeit, die ein Bildpunkt benötigt, um bei dieser Relativverschiebung von einer Spalte zur nächsten Spalte zu gelangen, und daß die Übertragung in das Ausgangsregister mit der gleichen Folgeperiode $\tau$ stattfindet, wobei die Anordnung die phasengleiche Addition der Signale vom gleichen Punkt des von den Detektoren in der gleichen Zeile im Verlauf dieser Relativverschiebung empfangenen Bildes gewährleistet.

7. Anordnung nach Anspruch 6, dadurch gekennzeichnet, daß die Folgeperiode $\tau$ auf einen weit über $t_1$ liegenden Wert eingestellt ist, wobei die Anordnung die Integration der von jedem Detektor während dieser Periode empfangenen Signale gewährleistet.

8. Anordnung nach Anspruch 5, dadurch gekennzeichnet, daß das Lesegerät ein Fernsehempfänger-Bildschirm ist und daß die Entleerungszeit der Kanäle C gleich der Teilbildperiode $T_t$ des von diesem Empfänger abgegebenen Bildes ist.

9. Anordnung nach Anspruch 7, dadurch gekennzeichnet, daß das Lesegerät ein Fernsehempfänger-Bildschirm ist und daß die Folgeperiode $\tau$ gleich der Integrationszeit des Bildes in diesem Empfänger ist.

10. Anordnung nach Anspruch 6, dadurch gekennzeichnet, daß die Folgeperiode $\tau$ im wesentlichen gleich der Zeit $t_1$ ist und daß die Übertragung aus den Kanälen A zu den Kanälen C direkt ohne Durchgang durch die Kanäle B stattfindet.

11. Anordnung nach Anspruch 3 oder 4, gekennzeichnet durch einen Umlaufspeicher, dessen Bits wie die Detektoren des Targets an Kreuzungspunkten von Zeilen und Spalten angeordnet sind, wobei in diesen Bits die von den Detektoren des Targets unter dem Einfluß einer gleichmäßigen einfallenden Strahlung gelieferten Signale gespeichert sind und wobei in dem Speicher Mittel zur Entnahme dieser letzteren Signale synchron den den Detektoren des Targets entsprechenden Signalen, Mittel zur Bildung der Differenz zwischen diesen Signalen und Mittel zum Eingeben der Differenzen in die Lesevorrichtung vorgesehen sind.

12. Anordnung nach Anspruch 3 oder 4, dadurch gekennzeichnet, daß das Target einen Ausgang pro Zeile aufweist.

13. Anordnung nach Anspruch 3 oder 4, dadurch gekennzeichnet, daß das Target pro Gruppe aus n aufeinanderfolgenden Zeilen einen Ausgang aufweist, wobei n ein ganzzahliger Teilfaktor der Anzahl N der Zeilen des Targets ist, und daß ein zwischen dem Target und der Lesevorrichtung angebrachtes Multiplexiersystem vorgesehen ist, das die zeilenweise Übertragung der Signale jeder Gruppe in einen der Eingänge der Lesevorrichtung gewährleistet.

FIG.1

# FIG.2

## FIG.3

## FIG.4

FIG.5

# Fig.6